# EUROPÄISCHE PATENTSCHRIFT

(11) **EP 1 984 957 B1**
(45) Veröffentlichungstag und Bekanntmachung des Hinweises auf die Patenterteilung: **13.06.2012**
(21) Anmeldenummer: 07703711.7
(22) Anmeldetag: 09.01.2007
(51) Int. Cl.: H01L 41/047, H01L 41/083

(54) **PIEZOKERAMISCHER VIELSCHICHT-AKTOR, VERFAHREN ZUM HERSTELLEN EINES PIEZOKERAMISCHEN VIELSCHICHT-AKTORS UND EINSPRITZSYSTEM**
PIEZOCERAMIC MULTILAYER ACTUATOR, METHOD FOR PRODUCING A PIEZOCERAMIC MULTILAYER ACTUATOR, AND INJECTION SYSTEM
ACTIVATEUR MULTICOUCHE PIÉZOCÉRAMIQUE, PROCÉDÉ DE FABRICATION D'UN ACTIVATEUR MULTICOUCHE PIÉZOCÉRAMIQUE ET SYSTÈME D'INJECTION

(30) Priorität: 09.02.2006 DE 102006006077
(43) Veröffentlichungstag der Anmeldung: 29.10.2008
(73) Patentinhaber: Continental Automotive GmbH, 30165 Hannover (DE)
(72) Erfinder: KRONBERGER, Maximilian, 93053 Regensburg (DE)
(86) Internationale Anmeldenummer: PCT/EP2007/050160
(87) Internationale Veröffentlichungsnummer: WO 2007/090698

(56) Entgegenhaltungen:
- WO-A-2005/027235
- DE-A1- 19 928 189
- DE-A1-102004 005 227

## Beschreibung

Die Erfindung betrifft einen piezokeramischen Vielschicht-Aktor, ein Verfahren zum Herstellen eines piezokeramischen Vielschicht-Aktors und ein Einspritzsystem mit einem piezokeramischen Vielschicht-Aktor.

Einspritzsysteme und insbesondere lecköllose Common-Rail-Einspritzsysteme erfordern ein Steuerelement wie beispielsweise einen Piezo-Aktor oder piezokeramischen Vielschicht-Aktor im Hochdruckraum. Um die Arbeitsfähigkeit des Piezo-Aktors auch unter hohen Drücken bis über 2000 bar zu gewährleisten, muss der Druck auch seitlich auf den Piezo-Stapel beziehungsweise Piezo-Keramikkörper wirken können, um die Dehnungsfähigkeit des Piezo-Stapels des Piezo-Aktors zu unterstützen.

Ein solcher Piezo-Aktor ist beispielsweise in der WO 02/061856 A1 beschrieben. Dabei ist der Keramikkörper dieses Piezo-Aktors mit einer Polymer- oder Plastikmanschette umhüllt. Allerdings ist eine hermetische Abdichtung des Keramikkörpers gegenüber dem Kraftstoff unter einem hohen Kraftstoffdruck wie beispielsweise 2000 bar bei den zum Anmeldetag der vorliegenden Patentanmeldung bekannten Kunststoffen kaum oder nicht machbar. Wegen einer fallweise unvermeidbaren elektrischen Leitfähigkeit handelsüblicher Kraftstoffe, zum Beispiel aufgrund eines geringen Säuregehalts, kann es schon bei geringer Benetzung der Piezo-Keramik zu Spannungsüberschlägen zwischen den Innenelektroden des Piezo-Aktors kommen. Zudem treten an den Polungsrissen hohe Dehnungen der Kunststoffumhüllung auf, die dieses Problem verschärfen. Außerdem ist in der WO 02/061856 die Verwendung eines Füllmaterials zwischen dem Piezo-Stapel und der Polymer- oder Plastikmanschette beschrieben. Bei dem beschriebenen Füllmaterial besteht allerdings das Problem, dass es bei einer Dehnung des Piezo-Stapels in entstehende Zwischenräume oder Fugen fließen kann und bei einer entgegengesetzt gerichteten Bewegung des Piezo-Stapels zerstört werden kann. Somit wird über die Betriebsdauer des Piezo-Aktors das Füllmaterial aufgebraucht oder zerstört. Das verminderte Füllmaterial bedingt allerdings, dass der außen an dem Piezo-Aktor anliegende Druck nicht mehr effizient auf den Piezo-Stapel übertragen werden kann.

Ein weiteres Beispiel findet sich in WO2005/27235.

Außerdem ist der Anmelderin zur Übertragung des Druckes auf den Piezo-Stapel des Piezo-Aktors eine Lösung mit einer hermetisch dichten metallischen Hülse bekannt, die die hydraulischen Kräfte mittels eines Füllstoffes, zum Beispiel aus Kunststoff, auf die Seitenflächen des Piezo-Keramikkörpers überträgt. Diese der Anmelderin bekannte Lösung hat allerdings den Nachteil, dass die Wärmeausdehnungskoeffizienten von Kunststoffen um Größenordnungen über dem der Piezo-Keramik liegen, was folglich einen Volumenausgleich zum Beispiel mittels luft-oder gasgefüllter Hohlräume erfordert. Diese erforderlichen Hohlräume reduzieren allerdings die seitlich übertragbaren Kräfte auf die Piezo-Keramik beziehungsweise den Piezo-Stapel erheblich, so dass die Unterstützung der Längsdehnung des Piezo-Stapels deutlich verringert wird.

Außerdem besteht bei der dieser bekannten Lösung das Problem des erhöhten notwendigen Platzbedarf des Aktors. Denn aufgrund der im Vergleich zur Metallhülle hohen Wärmedehnungskoeffizienten von Kunststoffen darf das Volumen des Füllstoffes eine bestimmte Größe nicht überschreiten, da ansonsten die maximal ertragbaren Spannungsamplituden der Metallhülle bei den im Betrieb auftretenden extremen Kombinationen von Temperatur und Druck überschritten würden. Bei einer wie oben beschriebenen Füllung der Hohlräume zwischen Hülle und Piezostapel ist die notwendige Volumenminimierung für eine kompakte und platzsparende Bauweise des Vielschicht-Aktors schwierig bzw. unmöglich, da werden muss, um bei den herstellungsbedingten gegebenen Formungenauigkeiten sowie den betriebsbedingten Formänderungen des Piezostapels und der Metallhülle überall eine ausreichende Passivierungsdicke sicherzustellen.

Des Weiteren ist der Anmelderin eine Kontaktierung des Piezostapels mit einer kompakten Bauweise bekannt, welche aus je einem Metallstift von circa 1 mm Durchmesser für Plus- und Minuspol besteht, der mit jeweils etwa 60 Drähten mit der Außenmetallisierung des Piezostapels elektrisch leitend verbunden ist. Diese Stifte reichen vorzugsweise über die gesamte Länge des Piezostapels. Dabei sind die Drähte mit gleichen Abständen an Stift und Außenmetallisierung des Piezostapels befestigt, so dass bei einer Unterbrechung der Metallisierung oder eines Drahtes maximal 1/60 der elektrischen Kapazität des Piezostapels verloren geht. Allerdings ist diese Lösung nicht dazu geeignet, dass die Kontaktierung, insbesondere die Stifte für Plus- und Minuspol Bewegungen, insbesondere Dehnungen des Piezostapels mitmachen. Außerdem ist die Herstellung der Kontaktierung mittels Metallstiften und zugehörigen Drähte zur Kontaktierung der Metallisierung des Piezostapels aufwendig. Weiter ist die Strombelastbarkeit der aus Stiften und Drähten bestehenden Außenkontaktierung bzw. Außenelektrode des Piezostapels gering. Dies führt insbesondere bei lokalen Kurzschlüssen zu Problemen, die bis zur Zerstörung des Vielschicht-Aktors führen können.

Aus der WO 2005/027235 ist ein Piezoaktor mit einer Piezokeramik bekannt, die sich beim Anlegen einer Spannung ausdehnen kann und mit Kontaktierungen, die an der Piezokeramik anliegen und als Formbleche ausgeführt sind, die voneinander beabstandete Kontaktflächen aufweisen.

Ein aus der DE 10 2004 005 227 A1 bekannter Piezoaktor weist einen Aktorkörper aus einem piezoelektrischen Material und mindestens ein Paar Innenelektroden auf. Die Innenelektroden sind in dem Aktorkörper angeordnet, nach außen geführt und jeweils einzeln an einer Außenfläche des Aktorkörpers mittels einer von zwei Außenelektroden kontaktiert. Die Außenelektroden sind dabei derart groß ausgebildet, dass sie die nach außen geführten Innenelektroden an der Außenfläche des Aktorkörpers im Wesentlichen vollständig überdecken.

Eine Aufgabe der vorliegenden Erfindung besteht darin, einen piezokeramischen Vielschicht-Aktor, insbesondere einen möglichst kompakten piezokeramischen Vielschicht-Aktor bereitzustellen, bei dem eine elektrische Unterbrechung einer Außenelektrode des Vielschicht-Aktors zu keinem oder nur einem minimalen Verlust an betriebsfähigen Piezoschichten führt.

Eine weitere Aufgabe ist es, einen piezokeramischen Vielschicht-Aktor, insbesondere einen möglichst kompakten piezokeramischen Vielschicht-Aktor, mit einer hohen Strombelastbarkeit zu schaffen, bei dem eine elektrische Unterbrechung einer Außenelektrode des Vielschicht-Aktors zu keinem oder nur zu einem minimalen Verlust an betriebsfähigen Piezoschichten führt.

Eine weitere Aufgabe der vorliegenden Erfindung besteht darin, einen piezokeramischen Vielschicht-Aktor bereitzustellen, bei welchem ein außen an den Vielschicht-Aktor anliegender Druck auf den Piezostapel des Vielschicht-Aktors möglichst effizient übertragen und insbesondere verteilt wird.

Des Weiteren ist es eine Aufgabe der vorliegenden Erfindung, einen Vielschicht-Aktor zu schaffen, welcher insbesondere auch in einer Umgebung hohen Druckes, beispielsweise auch bei über 2000 bar, vor Spannungsüberschlägen geschützt ist.

Erfindungsgemäß wird zumindest eine dieser gestellten Aufgaben durch einen piezokeramischen Vielschicht-Aktor mit den Merkmalen des Patentanspruchs 1 und/oder durch ein Verfahren mit den Merkmalen des Patentanspruchs 22 und/oder durch ein Einspritzsystem mit den Merkmalen des Patentanspruchs 23 gelöst.

Demnach wird erfindungsgemäß ein piezokeramischer Vielschicht-Aktor mit einem Piezostapel, der eine Vielzahl N von Piezoschichten aufweist, vorgeschlagen, wobei zumindest eine dehnfähige Außenelektrode zumindest zwei Strompfade zwischen einem Versorgungspotentialanschlussbereich der Außenelektrode und einer jeweiligen durch die Außenelektrode kontaktierten Innenelektrode des Piezostapels bereitstellt.

Somit existiert vorteilhafterweise auch bei einer lokalen Unterbrechung zwischen einer beliebigen Innenelektrode und der entsprechenden Außenelektrode und/oder einer Unterbrechung zwischen dieser Innenelektrode und einer zu dieser Innenelektrode benachbarten Innenelektrode zumindest ein weiterer Strompfad zwischen dieser Innenelektrode und der entsprechenden Außenelektrode. Der weitere Strompfad kann direkt zwischen dieser Innenelektrode und dem Versorgungspotentialanschlussbereich der Außenelektrode oder über die Metallisierung und eine andere Innenelektrode zu dem Versorgungspotentialanschlussbereich laufen. Somit ist vorteilhafterweise auch diese besagte Innenelektrode, die von der Unterbrechung oder den Unterbrechungen betroffen wäre, mit elektrischen Strom versorgt, so dass die entsprechende Piezoschicht, die mittels der besagten Innenelektrode angesteuert wird, betriebsfähig bleibt. Im Sinne dieser Anmeldung ist mit Unterbrechung eine Stelle gemeint, über welche insbesondere aufgrund einer mechanischen Überbeanspruchung bzw. eines Risses des Materials kein elektrischer Strom mehr fließen kann.

Die erfindungsgemäße Ausgestaltung der Außenelektrode stellt somit eine Redundanzvorrichtung für eine redundante Versorgung der zu kontaktierenden Innenelektroden mit elektrischem Strom bereit. Damit wird selbst bei einer lokalen Unterbrechung der Außenelektrode sichergestellt, dass der Piezostapel keine elektrische Kapazität bzw. keine betriebsfähigen Piezoschichten verliert.

Außerdem ist die erfindungsgemäße Außenelektrode dehnfähig ausgestaltet, so dass sie auch dazu geeignet ist, jegliche Bewegungen des Piezostapels, insbesondere dessen Längsbewegungen mitzumachen. Durch die Dehnfähigkeit und Beweglichkeit der Außenelektrode wird sichergestellt, dass nur minimale bzw. keine Zug- oder Schubspannungen an der Außenelektrode auftreten können. Somit wird die Wahrscheinlichkeit für eine mechanische negative Beeinflussung oder Zerstörung der Außenelektrode minimiert. Damit wird auch die Wahrscheinlichkeit für eine Unterbrechung der Außenelektrode minimiert.

Vorteilhafte Ausgestaltungen und Weiterbildungen der Erfindungen ergeben sich aus den Unteransprüchen sowie der Beschreibung unter Bezugnahme auf die Zeichnungen.

Gemäß einer bevorzugten Ausgestaltung der Erfindung ist der Piezostapel kreiszylindrisch ausgebildet. Nachdem in der Regel zylinderförmige Vielschicht-Aktoren bzw. Piezo-Aktoren eingesetzt werden, ist es durch den Einsatz des zylinderförmigen Piezostapels möglich, dass der Abstand zwischen der Mantelfläche des Piezostapels in einer Querschnittsebene im Wesentlichen überall gleich zur Außenmantelfläche des Vielschicht-Aktors ist. Dadurch wird der Raum innerhalb des Vielschicht-Aktors besser als bei herkömmlichen eckigen Piezo-Stapeln ausgenutzt. Der zylinderförmige Piezostapel wird beispielsweise hergestellt, indem er mit einem Kronenbohrer aus einem fertig geschichteten und gepressten Piezoblock geschnitten wird.

Gemäß einer weiteren bevorzugten Ausgestaltung weist die Außenelektrode eine im Wesentlichen an eine Mantelfläche des Piezostapel angepasste flächige Form auf und umgibt den Piezostapel zumindest teilweise. Die flächige Form der Außenelektrode hat den Vorteil, dass das Volumen der Außenelektrode sehr groß ist und folglich die Strombelastbarkeit der Außenelektrode sehr hoch ist. Durch die Anpassung der flächigen Außenelektrode an die Mantelfläche des Piezostapels wird das Volumen der Außenelektrode ohne eine Vergrößerung der Dicke der Außenelektrode und damit ohne eine Einschränkung der Kompaktheit des Vielschicht-Aktors deutlich vergrößert bzw. maximiert und die Strombelastbarkeit der Außenelektrode weiter deutlich erhöht. Vorzugsweise ist die Außenelektrode als ein im Wesentlichen an die Mantelfläche des Piezostapels angepasstes flächiges Streckmetall oder Lochblech oder Drahtnetz, zum Beispiel aus Invar, oder Rohrfeder ausgebildet.

Gemäß einer weiteren bevorzugten Weiterbildung umspannt die Außenelektrode einen Bereich von 30 % bis 50 %, bevorzugt 40 % bis 49 %, besonders bevorzugt 45 % bis 49 %, eines halben Umfanges des Piezo-Stapels.

Gemäß einer weiteren bevorzugten Ausgestaltung weist der Piezostapel eine Vielzahl N von ersten Innenelektroden und eine Vielzahl N von zweiten Innenelektroden auf, wobei eine Piezoschicht zwischen einer ersten Innenelektrode und einer zweiten Innenelektrode angeordnet ist und die Vielzahl N erster Innenelektroden mit einer ersten Außenelektrode und die Vielzahl N zweiter Innenelektroden mit einer zweiten Außenelektrode elektrisch gekoppelt ist.

Gemäß einer weiteren bevorzugten Ausgestaltung umspannen die erste Außenelektrode und die zweite Außenelektrode den Piezostapel im Wesentlichen, wobei die erste Außenelektrode mit einer ersten Metallisierung, welche die N ersten Innenelektroden elektrisch kontaktiert, und die zweite Außenelektrode mit einer zweiten Metallisierung, welche die N zweiten Innenelektroden elektrisch kontaktiert, verbunden und insbesondere elektrisch kontaktiert ist. Dadurch dass die erste Außenelektrode und die zweite Außenelektrode den Piezostapel im Wesentlichen umspannen, ergibt sich ein erhöhtes Volumen für die erste Außenelektrode und die zweite Außenelektrode ohne eine Erhöhung der Dicke der Außenelektroden, so dass keine Einschränkung der Kompaktheit des Vielschicht-Aktors in Kauf genommen werden muss. Eine Erhöhung des Volumens der Außenelektroden führt vorteilhafterweise zu einer erhöhten Strombelastbarkeit dieser.

Gemäß einer weiteren bevorzugten Ausgestaltung weist die Außenelektrode auf:
- den Versorgungspotenzialanschlussbereich;
- eine Vielzahl von N Fingern, welche parallel auf der Metallisierung jeweils im Bereich einer Innenelektrode elektronisch kontaktiert sind;
- eine in axialer Richtung des Piezo-Stapels parallel angeordnete Vielzahl N von Kontaktstegen, welche den Piezo-Stapel in Umfangsrichtung umspannen und einen ersten Abstand zum Piezo-Stapel aufweisen, wobei jeweils zwei benachbarte Kontaktstege mittels zumindest eines in Umfangsrichtung angeordneten Schlitzes zur Erhöhung der Dehnungsfähigkeit der Außenelektrode voneinander getrennt sind und mittels zumindest eines in Längsrichtung des Piezo-Stapels angeordneten Brückenabschnitts zur Stromführung miteinander verbunden sind;
- eine in Querrichtung des Piezo-Stapels angeordnete Vielzahl N von Verbindungsabschnitten, wobei jeweils ein Verbindungsabschnitt einen jeweiligen Finger mit dem entsprechenden Kontaktsteg elektrisch verbindet.

Erfindungsgemäß sind dabei die in Längsrichtung benachbarten Schlitze in Umfangsrichtung versetzt zueinander angeordnet.

Erfindungsgemäß weist die Außenelektrode weiterhin auf:
- den Versorgungspotenzialanschlussbereich;
- einen in Längsrichtung des Piezo-Stapels angeordneten, ersten mäanderförmigen Abschnitt, welcher mit dem Versorgungspotenzialanschlussbereich elektrisch gekoppelt ist und welcher eine Vielzahl N/2 von ersten Kurvenabschnitten aufweist;
- einen parallel zum ersten mäanderförmigen Abschnitt angeordneten, zweiten mäanderförmigen Abschnitt, welcher mit dem Versorgungspotenzialanschlussbereich elektrisch gekoppelt ist und welcher eine Vielzahl N/2 von zweiten Kurvenabschnitten aufweist; und
- eine Vielzahl von N Fingern, welche parallel auf der Metallisierung jeweils im Bereich einer Innenelektrode elektrisch kontaktiert sind und welche alternierend mit dem ersten mäanderförmigen Abschnitt oder mit dem zweiten mäanderförmigen Abschnitt elektrisch gekoppelt sind.

Gemäß einer weiteren bevorzugten Ausgestaltung ist jeder (2n)-te Finger, mit n ∈ [1,...,N], mit dem jeweiligen ersten Kurvenabschnitt und jeder (2n+1)-te Finger mit dem jeweiligen zweiten Kurvenabschnitt verbunden.

Gemäß einer weiteren bevorzugten Ausgestaltung ist jeder Finger im Bereich eines Scheitelpunktes des entsprechenden Kurvenabschnittes mit dem entsprechenden Kurvenabschnitt verbunden.

Durch das alternierende Anschließen der Finger an den ersten mäanderförmigen Abschnitt beziehungsweise den zweiten mäanderförmigen Abschnitt wird eine optimale Dehnfähigkeit der Außenelektrode bereitgestellt. Insgesamt stellt die Konfiguration des alternierenden Anschließens einen optimalen Kompromiss zwischen der Dehnfähigkeit, der Druckübertragungsfähigkeit und der Redundanzfähigkeit der Außenelektrode bereit.

Gemäß einer weiteren bevorzugten Ausgestaltung sind/ist die erste Außenelektrode mit der ersten Metallisierung mittels einer Schweißverbindung oder mittels zumindest eines Bondingdrahtes und/oder die zweite Außenelektrode mit der zweiten Metallisierung mittels einer Schweißverbindung oder mittels zumindest eines Bondingdrahtes verbunden. Alternativ ist es auch denkbar, die erste Außenelektrode und die erste Metallisierung und/oder die zweite Außenelektrode und die zweite Metallisierung einstückig auszubilden.

Gemäß einer bevorzugten Weiterbildung der Erfindung weist der Piezostapel eine erste Freistellung in der Mantelfläche des Piezostapels auf, in der die erste Metallisierung angeordnet ist, und/oder der Piezostapel weist eine zweite Freistellung in der Mantelfläche des Piezostapels auf, in der die zweite Metallisierung angeordnet ist. Vorzugsweise ist die erste Freistellung derart tief, dass die erste Metallisierung innerhalb des durch den Radius des zylinderförmigen Piezostapels bestimmten Raumes verläuft und/oder die zweite Freistellung ist derart tief, dass die zweite Metallisierung innerhalb des durch den Radius des zylinderförmigen Piezostapels bestimmten Raumes verläuft. Durch diese erfindungsgemäße Anordnung der Metallisierungen innerhalb des durch den Radius des zylinderförmigen Piezostapels bestimmten Raumes wird Platz eingespart, was zu einer verbesserten kompakten Bauweise des Vielschicht-Aktors führt.

Gemäß einer weiteren bevorzugten Weiterbildung ist eine zumindest den Piezostapel, die erste Außenelektrode und die zweite Außenelektrode umgebende Umhüllung vorgesehen. Die Umhüllung ist vorzugsweise als ein Wellrohr ausgebildet, das eine Vielzahl von M Wellen aufweist und insbesondere metallisch ist. Insbesondere ist die dehnfähige Außenelektrode dazu geeignet, eine erste Relativbewegung zwischen der Umhüllung und der Außenelektrode und eine zweite Relativbewegung zwischen der Außenelektrode und dem Piezostapel aufzunehmen. Durch die Aufnahme der Relativbewegungen ist es erfindungsgemäß möglich, dass die Umhüllung sowie die Außenelektroden jegliche Bewegungen des Piezostapels mitmachen. Durch die wellrohrartige Ausgestaltung der Umhüllung ist es vorteilhafterweise möglich, die Aufnahme von Relativbewegungen zu verbessern. Das Wellrohr ist insbesondere metallisch und ermöglicht es vorteilhafterweise auch bei einer unvermeidbaren elektrischen Leitfähigkeit handelsüblicher Kraftstoffe, den piezokeramischen Vielschicht-Aktor vor Spannungsüberschlägen zu schützen. Vorteilhäfterweise sind die erste Außenelektrode und die zweite Außenelektrode dazu geeignet, einen außen an der Umhüllung anliegenden Druck auf den Piezostapel zu übertragen. Dies unterstützt vorteilhafterweise die Dehnfähigkeit des Piezostapels und verbessert dadurch die Betriebsfähigkeit des piezokeramischen Vielschicht-Aktors.

Gemäß einer weiteren bevorzugten Weiterbildung ist eine erste Passivierungsschicht zwischen dem Piezostapel und den Außenelektroden und eine zweite Passivierungsschicht zwischen den Außenelektroden und der Umhüllung vorgesehen. Die erste Passivierungsschicht und die zweite Passivierungsschicht bilden insbesondere jeweils eine Passivierungshülle für die erste Außenelektrode und die zweite Außenelektrode aus. Dadurch wird vorteilhafterweise ein Spannungsüberschlag zwischen dem Piezostapel und der Außenelektrode sowie jeglichen außerhalb der Außenelektrode angeordneten Einheiten oder Elementen, wie beispielsweise der Umhüllung vermieden.

Gemäß einer weiteren bevorzugten Ausgestaltung bestehen die erste Passivierungsschicht und/oder die zweite Passivierungsschicht im Wesentlichen aus einem Elastomer, insbesondere Teflon, oder aus einem Gel. Vorteilhafterweise wird durch die Beschichtung mit dem Elastomer bzw. durch die Umhüllung mit dem Gel eine verminderte bzw. eine minimale Reibung bei der Übertragung des außen anliegenden Druckes auf dem Piezostapel ermöglicht. Eine verminderte oder minimale Reibung führt zu einem minimalen Energieverlust bei der Übertragung und Verteilung des außen an dem Vielschicht-Aktor anliegenden Druckes.

Gemäß einer weiteren bevorzugten Weiterbildung ist ein O-Ringförmiges Stützelement in zumindest einer Welle des Wellrohres vorgesehen, welches insbesondere aus einem Elastomer, beispielsweise Teflon, besteht. Das O-Ringförmige Stützelement unterstützt die mechanische Stabilität des Wellrohres und trägt somit zu einer erhöhten Lebensdauer des Vielschicht-Aktors bei. Vorteilhafterweise ist das O-Ringförmige Stützelement mit einem Elastomer beschichtet, so dass nur verringerte oder minimale Reibungsverluste auftreten.

Gemäß einer weiteren bevorzugten Ausgestaltung ist das Wellrohr als ein längs- und/oder querdehnfähiges Wellrohr ausgebildet.

Gemäß einer weiteren bevorzugten Ausgestaltung ist der Vielschicht-Aktor kreiszylindrisch ausgebildet.

Gemäß einer weiteren bevorzugten Ausgestaltung weisen die erste Passivierungsschicht und/oder die zweite Passivierungsschicht eine Härte von zumindest 70 Shore A auf.

Gemäß einer weiteren bevorzugten Ausgestaltung ist für jede Außenelektrode ein Anschluss vorgesehen, welcher den Versorgungspotentialanschlussbereich der Außenelektrode zur Versorgung der entsprechenden Innenelektrode mit einem Versorgungspotential kontaktiert.

Die Erfindung wird nachfolgend anhand der in den schematischen Figuren der Zeichnung angegebenen Ausführungsbeispielen näher erläutert. Es zeigen:
- Fig. 1a: eine perspektivische Ansicht eines bevorzugten Ausführungsbeispiels der Außenelektrode gemäß der vorliegenden Erfindung;
- Fig. 1b: eine schematische Querschnittsansicht eines Piezostapels, der mit der erfindungsgemäßen Außenelektrode gemäß Fig. 1a koppelbar ist;
- Fig. 2: eine Vorderansicht eines ersten Ausführungsbeispiels des erfindungsgemäßen Vielschicht-Aktors;
- Fig. 3: eine Seitenansicht des ersten Ausführungsbeispiels des erfindungsgemäßen Vielschicht-Aktors nach Fig. 2;
- Fig. 4: eine perspektivische Ansicht des ersten Ausführungsbeispiels des erfindungsgemäßen Vielschicht-Aktors nach den Fig. 2 und 3;
- Fig. 5: eine schematische Querschnittsansicht eines zweiten Ausführungsbeispiels des erfindungsgemäßen Vielschicht-Aktors;
- Fig. 6: eine schematische Querschnittsansicht eines dritten Ausführungsbeispiels des erfindungsgemäßen Vielschicht-Aktors;
- Fig. 7: eine schematische Querschnittsansicht eines vierten Ausführungsbeispiels des erfindungsgemäßen Vielschicht-Aktors.
- Fig. 8: eine perspektivische Ansicht eines weiteren bevorzugten Ausführungsbeispiels der Außenelektrode gemäß der vorliegenden Erfindung;
- Fig. 9a: eine perspektivische Ansicht eines fünften Ausführungsbeispiels des Vielschicht-Aktors, der die erfindungsgemäße Außenelektrode gemäß Figur 8 aufweist; und
- Fig. 9b: eine um 90° gedrehte, perspektivische Ansicht des fünften Ausführungsbeispiels des Vielschicht-Aktors gemäß Figur 9a.

In allen Figuren sind gleiche bzw. funktionsgleiche Elemente und Einheiten - sofern nichts anderes angegeben ist - mit denselben Bezugszeichen versehen worden.

Den im Folgenden erläuterten Ausführungsbeispielen des erfindungsgemäßen piezokeramischen Vielschicht-Aktors 1 ist gemein, dass zumindest eine Außenelektrode 4, 5, die die jeweiligen Innenelektroden mit einem Plus- oder Minuspol einer Versorgungsspannungsquelle kontaktiert, dehnfähig ausgestaltet ist und zumindest zwei Strompfade zwischen einem Versorgungspotentialanschlussbereich 4a, 5a der Außenelektrode 4, 5 und zumindest einer durch die Außenelektrode 4, 5 kontaktierten Innenelektrode 6, 7 des Piezostapels 2 bereitstellt.

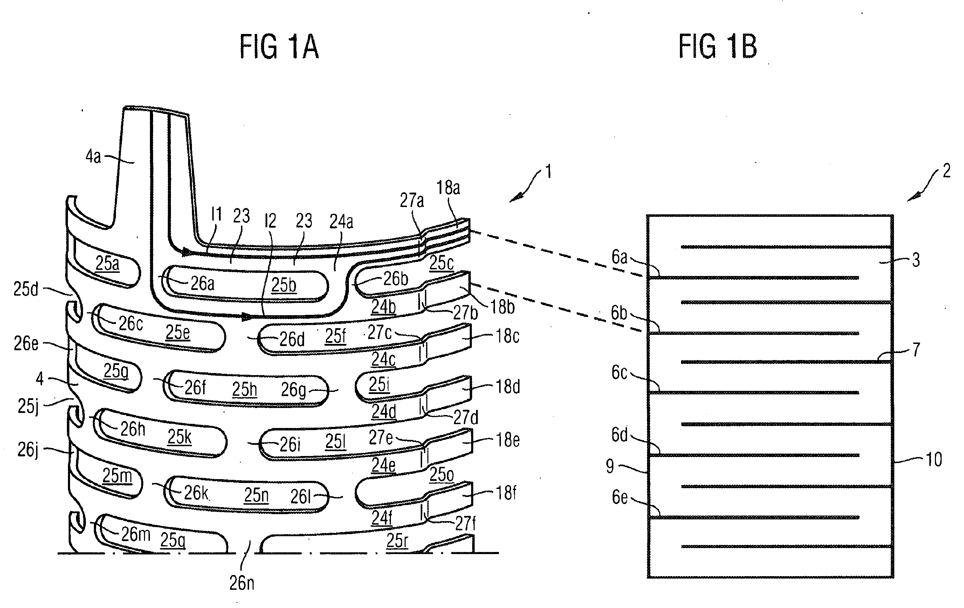

In Fig. 1 ist eine perspektivische Ansicht eines Ausführungsbeispiels der erfindungsgemäßen Außenelektrode 4 dargestellt. Die erfindungsgemäße Außenelektrode 4 nach Fig. 1a weist in ihren seitlich auslaufenden Bereichen Finger 18a - 18f zur Kontaktierung des Piezostapels 2 auf.

Fig. 1b zeigt eine schematische Querschnittsansicht eines Piezostapels 2, der mit der erfindungsgemäßen Außenelektrode 4 gemäß Fig. 1a koppelbar ist. Der Piezostapel 2 weist eine Vielzahl N von ersten Innenelektroden 6 und eine Vielzahl N von zweiten Innenelektroden 7 auf. Dabei ist eine Piezoschicht 3 zwischen einer ersten Innenelektrode 6 und einer zweiten Innenelektrode 7 angeordnet. Die Vielzahl N erster Innenelektroden 6 ist über eine erste Metallisierung 9 mit einer ersten Außenelektrode 4 gemäß Fig. 1a zu koppeln. Die Vielzahl N zweiter Innenelektroden 7 ist über eine zweite Metallisierung 10 mit einer zweiten Außenelektrode 5 (nicht in den Fig. 1a und 1b dargestellt) zu koppeln. Die elektrische Kopplung der ersten Außenelektrode 4 gemäß Fig. 1a mit der ersten Metallisierung 9, mit welcher die ersten Innenelektroden 6 verbunden sind, ist mittels gestrichelter Linien zwischen den Fig. 1a und 1b ausschnittsweise dargestellt.

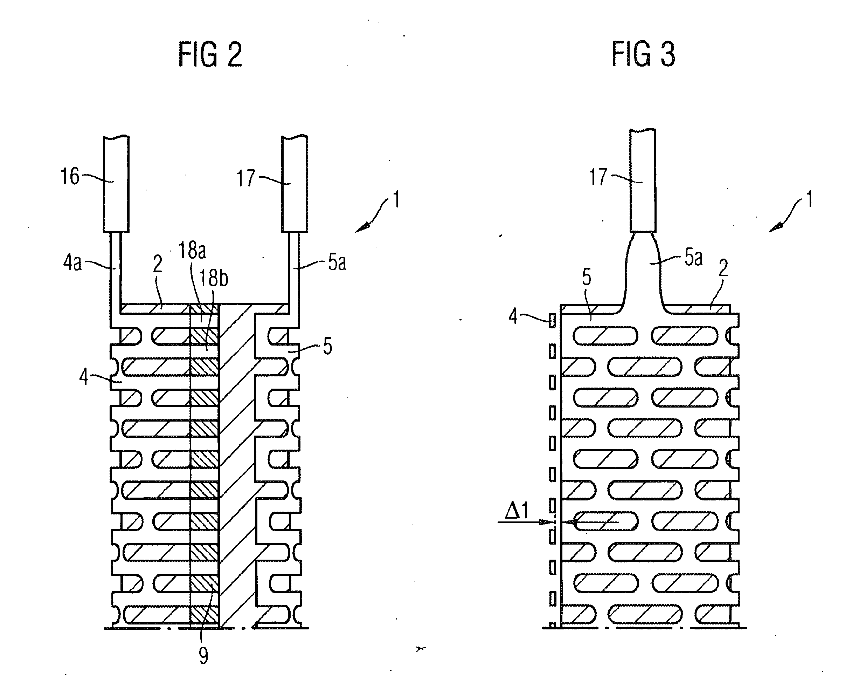

Die erfindungsgemäße Außenelektrode 4 weist eine Vielzahl von Fingern 18a - 18f auf. Insbesondere ist ein Finger, beispielsweise der Finger 18a, mit der ersten Metallisierung 9 im Bereich einer Innenelektrode 6 verbunden. Beispielsweise existieren zwischen der Innenelektrode 6, die mit dem Finger 18a verbunden ist, die zwei verschiedenen Strompfade I1 und I2 zwischen dieser Innenelektrode 6 und dem Versorgungspotentialanschlussbereich 4a der Außenelektrode 4. Der Versorgungspotentialanschlussbereich 4a ist mit einem Anschluss 16 (siehe Fig. 2) koppelbar. Über den Anschluss sind ist die Außenelektrode 4 sowie die mit der Außenelektrode 4 gekoppelten ersten Innenelektroden 6 auf ein vorbestimmtes Versorgungspotential legbar. Würde beispielsweise die Außenelektrode 4 im Bereich 23 unterbrochen werden, so ist zwar der erste Strompfad I1, aber nicht der zweite Strompfad I2 unterbrochen. Außerdem ergibt sich eine Vielzahl weiterer Strompfade für die oberste erste Innenelektrode 6 gemäß Fig. 1b über die erste Metallisierung 9 und der mit der ersten Metallisierung 9 gekoppelten Finger 18b - 18f der ersten Außenelektrode 4. Für alle anderen Innenelektroden 6 gilt Analoges.

Die Außenelektrode 4 weist den Versorgungspotenzialanschlussbereich 4a, eine Vielzahl N von Fingern 18a - 18f, eine Vielzahl N von Kontaktstegen 24a - 24f und eine Vielzahl N von Verbindungsabschnitten 27a - 27f auf. Die N Finger 18a - 18f sind parallel auf der Metallisierung 9 jeweils im Bereich einer Innenelektrode 6a- 6e elektronisch kontaktiert. Die Vielzahl N der Kontaktstege 24a - 24f ist in axialer Richtung des Piezo-Stapels 2 parallel angeordnet. Die N Kontaktstege 24a - 24f umspannen den Piezo-Stapel in Umfangsrichtung und weisen einen vorbestimmten Abstand Δ1 zum Piezo-Stapel 2 auf (siehe Figur 3). Jeweils zwei benachbarte Kontaktstege 24a - 24f sind mittels zumindest eines in Umfangsrichtung des Piezo-Stapels 2 angeordneten Schlitzes 25a - 25r zur Erhöhung der Dehnungsfähigkeit der Außenelektrode 4 voneinander getrennt und mittels zumindest eines in Längsrichtung des Piezo-Stapels 2 angeordneten Brückenabschnitts 26a - 26n zur Stromführung miteinander verbunden. Die N Verbindungsabschnitte 27a - 27f sind in Querrichtung des Piezo-Stapels 2 angeordnet, wobei jeweils ein Verbindungsabschnitt 27a - 27f einen jeweiligen Finger 28a - 28e mit dem entsprechenden Kontaktsteg 24a - 24f elektrisch verbindet.

Dabei sind die in Längsrichtung benachbarten Schlitze in Umfangsrichtung versetzt zueinander angeordnet.

Die Fig. 2 und 3 zeigen eine Vorderansicht bzw. eine Seitenansicht eines ersten Ausführungsbeispiels des erfindungsgemäßen Vielschicht-Aktors 1. Die erste Außenelektrode 4 und die zweite Außenelektrode 5 umspannen den Piezostapel 2 im Wesentlichen. Die erste Elektrode 4 ist mit dem ersten Anschluss 16 und die zweite Elektrode 5 ist mit einem zweiten Anschluss 17 gekoppelt. Der erste Anschluss 16 ist mit dem Versorgungspotentialanschlussbereich 4a der ersten Außenelektrode 4 zur Versorgung der ersten Innenelektroden 6 mit einem ersten Versorgungspotential gekoppelt und insbesondere kontaktiert. Der zweite Anschluss 17 ist mit einem Versorgungspotentialanschlussbereich 5a der zweiten Außenelektrode 5 zur Versorgung der zweiten Innenelektroden 7 mit einem zweiten Versorgungspotential kontaktiert. Beispielsweise ist der erste Anschluss 16 mit einem Pluspol einer Versorgungsspannung (nicht gezeichnet) und der zweite Anschluss 17 ist mit einem Minuspol der Versorgungsspannung verbunden. Dann lägen beispielsweise die ersten Elektroden 6 auf einem positiven Versorgungspotential und die zweiten Innenelektroden 7 auf einem negativen Versorgungspotential. Die Potentialdifferenz bzw. Spannung, die sich aus der Differenz des ersten Versorgungspotentials und des zweiten Versorgungspotentiales ergibt, dient zur Ansteuerung der Piezoschichten 3.

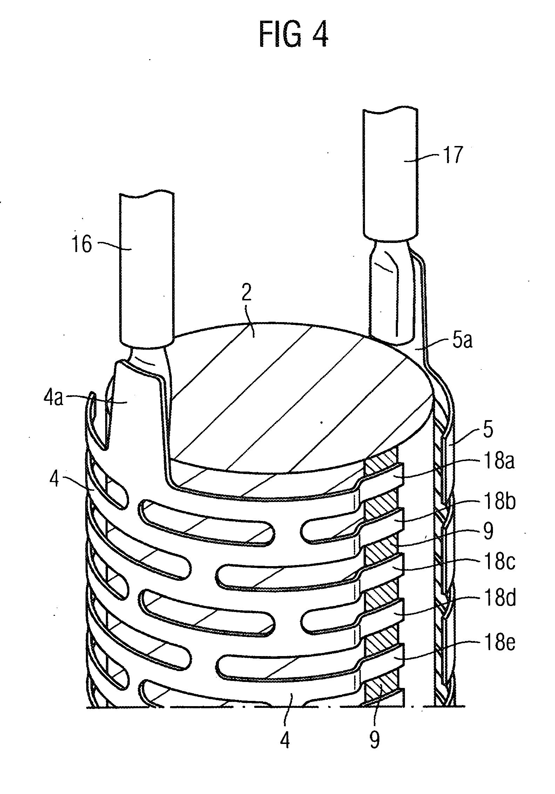

Fig. 4 zeigt eine perspektivische Ansicht des ersten Ausführungsbeispiels des erfindungsgemäßen Vielschicht-Aktors 1 gemäß der Fig. 2 und 3. Die jeweilige Außenelektrode 4, 5 ist mittels ihrer Finger 18a - 18e an der jeweiligen Metallisierung 9, 10 kontaktiert. Vorzugsweise ist die erste Außenelektrode 4 mit der ersten Metallisierung 9 mittels einer Schweißverbindung oder mittels zumindest eines Bondingdrahtes (nicht gezeigt) und/oder die zweite Außenelektrode 5 mit der zweiten Metallisierung 10 mittels einer Schweißverbindung oder mittels zumindest eines Bondingdrahtes verbunden. Alternativ können auch die erste Außenelektrode 4 und die erste Metallisierung 9 und/oder die zweite Außenelektrode 5 und die zweite Metallisierung 10 einstückig ausgebildet sein.

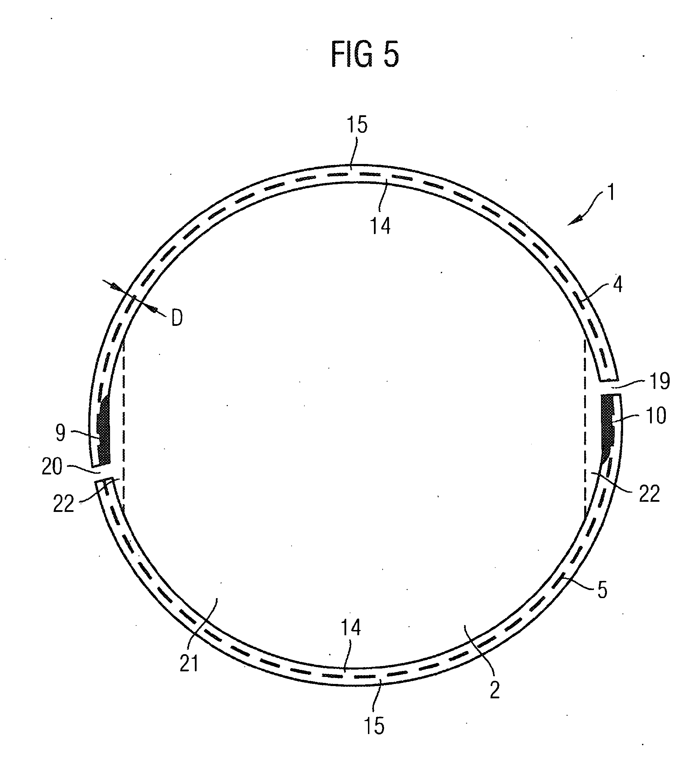

Fig. 5 zeigt eine schematische Querschnittsansicht eines zweiten Ausführungsbeispiels des erfindungsgemäßen piezokeramischen Vielschicht-Aktors 1. Der Piezostapel 2 des Vielschicht-Aktors 1 weist einen piezo-aktiven Bereich 21 und an zwei gegenüberliegenden Randbereiche jeweils einen piezo-passiven Bereich 22 auf. Innerhalb des piezo-passiven Bereichs 22 ist eine Metallisierung 9, 10 vorgesehen. Die erste Außenelektrode 4 ist mit der ersten Metallisierung 9 elektrisch gekoppelt, um die ersten Innenelektroden 6 anzusteuern. Die zweite Außenelektrode 5 ist mit der zweiten Metallisierung 10 elektrisch gekoppelt, um die zweiten Elektroden 7 anzusteuern.

Vorzugsweise ist eine erste Passivierungsschicht 14 zwischen dem Piezostapel 2 und den Außenelektroden 4, 5 angeordnet. Außerdem ist eine zweite Passivierungsschicht 15 über den Außenelektroden 4, 5 angeordnet. Die Passivierungsschichten 14, 15 bilden eine Passivierungshülle jeweils für die erste Außenelektrode 4 und für die zweite Außenelektrode 5 aus. Vorzugsweise weist die erste Passivierungsschicht 14 und/oder die zweite Passivierungsschicht 15 eine Härte von zumindest 70 Shore A auf. Die mit den Passivierungsschichten 14, 15 passivierten Außenelektroden 4, 5 bilden vorzugsweise ein Übertragungsmittel aus, welche einen außen an dem Vielschicht-Aktor anliegenden Druck auf den Piezostapel 2 überträgt und eine Dicke D von 10 µm - 1000 µm, bevorzugt 100 µm - 200 µm, aufweist. Die erste Außenelektrode 4 ist von der zweiten Metallisierung 10 mittels eines ersten Trennbereichs 19 elektrisch entkoppelt. Die zweite Außenelektrode 5 ist von der ersten Metallisierung 9 mittels eines zweiten Trennbereichs 20 elektrisch entkoppelt. Vorzugsweise ist der Piezostapel 2 kreiszylindrisch ausgebildet.

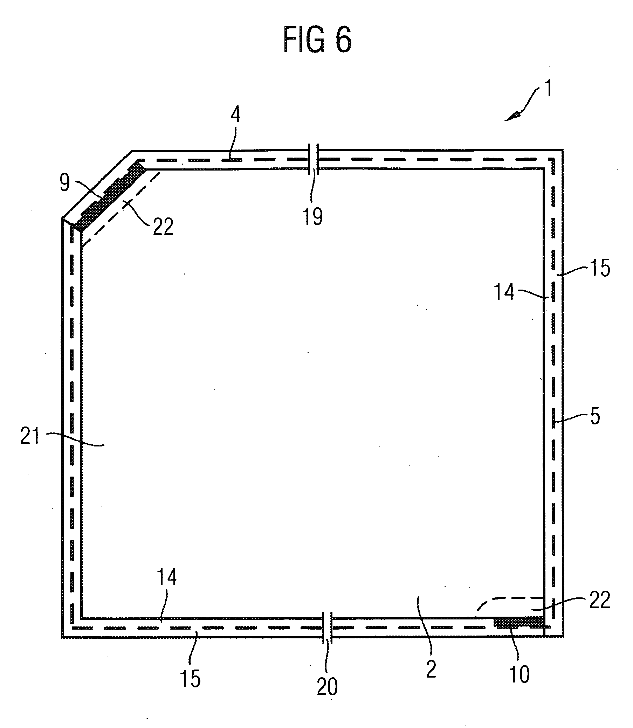

In Fig. 6 ist eine schematische Querschnittsansicht eines vierten Ausführungsbeispiels des erfindungsgemäßen Vielschicht-Aktors 1 dargestellt. Das dritte Ausführungsbeispiel gemäß Fig. 6 unterscheidet sich von dem zweiten Ausführungsbeispiels gemäß Fig. 5 dahingehend, dass der Piezostapel 2 nicht kreiszylindrisch, sondern im Wesentlichen quaderförmig ausgebildet ist. Es sind beispielsweise zwei unterschiedliche Ausführungsformen des piezo-passiven Bereichs 22 dargestellt.

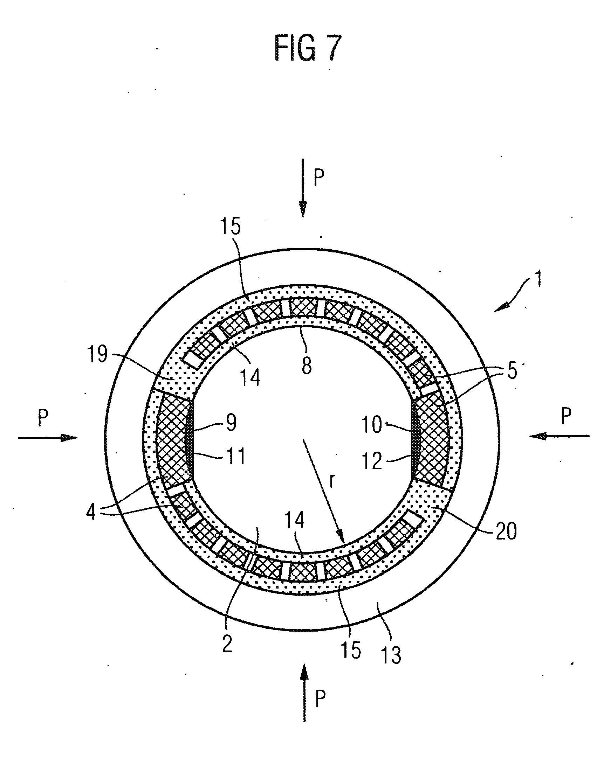

Fig. 7 zeigt eine schematische Querschnittsansicht eines vierten Ausführungsbeispiels des erfindungsgemäßen piezokeramischen Vielschicht-Aktors 1. Das vierte Ausführungsbeispiel gemäß Fig. 7 entspricht im Wesentlichen dem zweiten Ausführungsbeispiel gemäß Fig. 5. Darüber hinaus ist in dem vierten Ausführungsbeispiel gemäß Fig. 7 eine Umhüllung 13 vorgesehen, welche zumindest den Piezostapel 2, die erste Außenelektrode 4 und die zweite Außenelektrode 5 umgibt. Des Weiteren umgibt die Umhüllung 13 auch die erste Passivierungsschicht 14 und die zweite Passivierungsschicht 15, die zwei Passivierungshüllen für die erste Außenelektrode 4 und die zweite Außenelektrode 5 ausbilden.

Vorzugsweise weist der Piezostapel 2 eine erste Freistellung 11 in der Mantelfläche 8 des Piezostapels 2 auf, in der die erste Metallisierung 9 angeordnet ist. Weiter weist der Piezostapel 2 insbesondere eine zweite Freistellung 12 in der Mantelfläche 8 des Piezostapels 2, in der die zweite Metallisierung 10 angeordnet ist.

Insbesondere ist die erste Freistellung 11 derart tief, dass die erste Metallisierung 9 innerhalb des durch den Radius r des zylinderförmigen Piezostapels 2 bestimmten Raumes verläuft und/oder die zweite Freistellung 12 ist derart tief, dass die zweite Metallisierung 10 innerhalb des durch den Radius r des zylinderförmigen Piezostapels 2 bestimmten Raumes verläuft.

Beispielsweise ist die Umhüllung 13 als ein wellrohr ausgebildet, das eine Vielzahl von M Wellen aufweist und insbesondere metallisch ist. Außerdem ist vorzugsweise ein O-Ringförmiges Stützelement in zumindest einer Welle des Wellrohres 13 vorgesehen, welches insbesondere als einem Elastomer, beispielsweise Teflon, besteht. Das Wellrohr 13 ist vorzugsweise längs- und/oder querdehnfähig. Insgesamt ist der Vielschicht-Aktor 1 insbesondere kreiszylindrisch ausgebildet.

Insbesondere sind die erste Außenelektrode 4 und die zweite Außenelektrode 5 dazu geeignet, einen außen an der Umhüllung anliegenden Druck P zur Verbesserung der Dehnungsfähigkeit des Piezostapels 2 an den Piezostapel 2 zu übertragen.

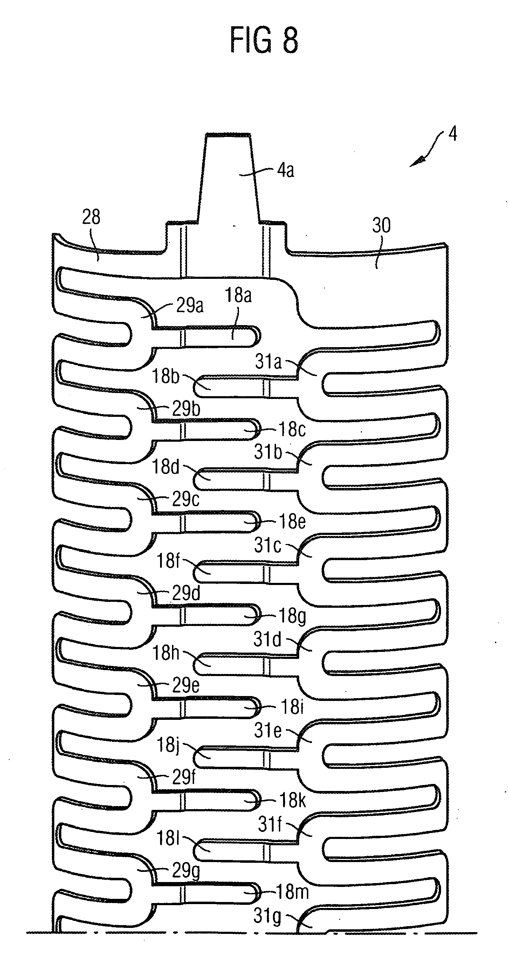

In Figur 8 ist eine perspektivische Ansicht eines weiteren bevorzugten Ausführungsbeispiels der Außenelektrode 4 gemäß der vorliegenden Erfindung dargestellt. Die Außenelektrode 4 weist den Versorgungspotenzialanschlussbereich 4a, einen ersten mäanderförmigen Abschnitt 28, einen zweiten mäanderförmigen Abschnitt 30 und eine Vielzahl von N Fingern 18a - 18m auf. Der erste mäanderförmige Abschnitt 28 ist in Längsrichtung des Piezostapels 2 angeordnet. Der erste mäanderförmige Abschnitt 28 ist mit dem Versorgungspotenzialanschlussbereich 4a elektrisch gekoppelt und weist eine Vielzahl N/2 von ersten Kurvenabschnitten 29a - 29g auf. Der zweite mäanderförmige Abschnitt 30 ist parallel zu dem ersten mäanderförmigen Abschnitt 28 angeordnet. Der zweite mäanderförmige Abschnitt 30 ist mit dem Versorgungspotenzialanschlussbereich 4a elektrisch gekoppelt, insbesondere verbunden. Der zweite mäanderförmige Abschnitt 30 weist eine Vielzahl N/2 von zweiten Kurvenabschnitten 31a - 31g auf. Die N Finger 18a - 18m sind parallel auf der Metallisierung 9 jeweils im Bereich einer Innenelektrode 6a - 6e elektrisch kontaktiert und sind alternierend mit dem ersten mäanderförmigen Abschnitt 28 oder mit dem zweiten mäanderförmigen Abschnitt 30 elektrisch gekoppelt. Insbesondere sind der Versorgungspotenzialanschlussbereich 4a, der erste mäanderförmige Abschnitt 28, der zweite mäanderförmige Abschnitt 30 sowie die Vielzahl N der Finger 18a - 18m einstückig zur Ausbildung der erfindungsgemäßen Außenelektrode 4 ausgebildet.

Vorzugsweise ist jeder (2n)-te Finger 18a, 18c, 18e, 18g, 18i, 18k, 18m, mit n∈ [1,...,N], mit dem jeweiligen ersten Kurvenabschnitt 29a - 29g und jeder (2n+1)-te Finger 18b, 18d, 18f, 18h, 18j, 181 mit dem jeweiligen Kurvenabschnitt 31a - 31g verbunden.

Insbesondere ist jeder Finger 18a - 18m im Bereich eines Scheitelpunktes des entsprechenden Kurvenabschnitts 29a - 29g; 31a - 31g mit dem entsprechenden Kurvenabschnitt 29a - 29g, 31a - 31g verbunden.

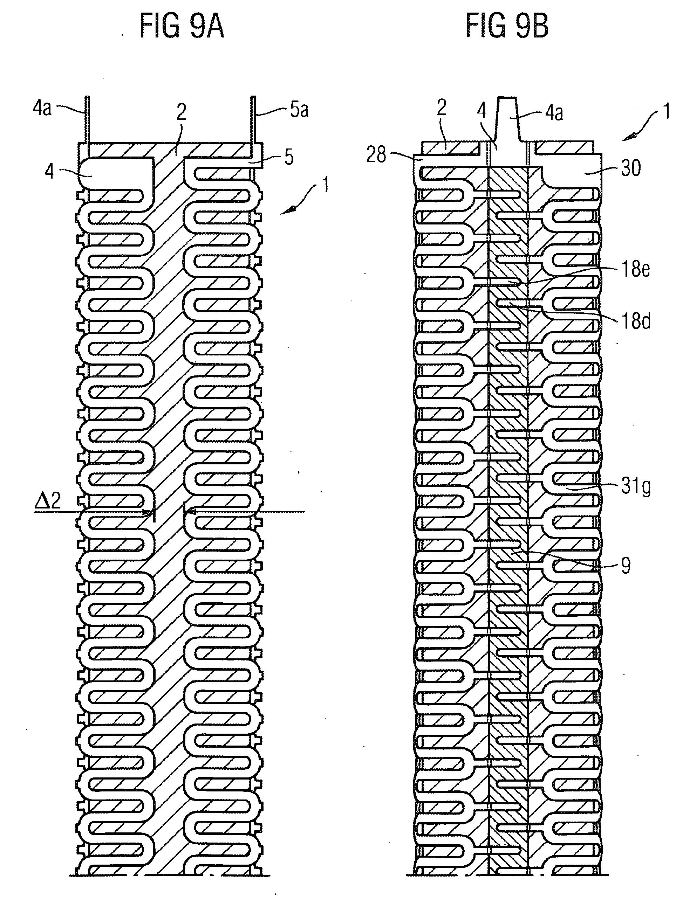

Figur 9a zeigt eine perspektivische Ansicht eines fünften Ausführungsbeispiels des Vielschicht-Aktors 1, der die erfindungsgemäße Außenelektrode 4 sowie eine zur Außenelektrode 4 baugleiche Außenelektrode 5 aufweist. Figur 9a zeigt, dass die erste Außenelektrode 4 und die zweite Außenelektrode 5 den Piezo-Stapel 2 im Wesentlichen umspannen. Dabei umspannt die jeweilige Außenelektrode 4, 5 einen Bereich von 30 % bis 50 %, bevorzugt 40 % bis 49 %, besonders bevorzugt 45 % bis 49 % des halben Umfangs des Piezo-Stapels 2. Die erste Außenelektrode 4 und die zweite Außenelektrode 5 sind auf jeder Seite durch einen zweiten Abstand Δ2 beabstandet.

Figur 9b zeigt eine um 90° gedrehte, perspektivische Ansicht des fünften Ausführungsbeispiels des Vielschicht-Aktors 1 gemäß Figur 9a. Dabei ist nur die erste Außenelektrode 4, nicht aber die zweite Außenelektrode 5 zu sehen. Die erste Außenelektrode 4 ist über ihre Finger 18e, 18d (aus Gründen der Übersichtlichkeit sind nur diese beiden Finger mit Bezugszeichen versehen worden) mit der ersten Metallisierung 9 elektrisch gekoppelt.

Nachfolgend wird das erfindungsgemäße Verfahren zum Herstellen eines piezokeramischen Vielschicht-Aktors 1 erläutert. Das erfindungsgemäße Verfahren weist folgende Verfahrensschritte a und b auf:

### Verfahrensschritt a:

Es wird ein Piezostapel 2 bereitgestellt, der eine Vielzahl N von Piezoschichten 3 aufweist.

### Verfahrensschritt b:

Es wird zumindest eine dehnfähige Außenelektroden 4, 5 an dem Piezostapel 2 angeordnet, wobei die Außenelektrode 4, 5 zumindest zwei Strompfade I1, I2 zwischen einem Versorgungspotentialanschlussbereich 4a, 5a der Außenelektrode 4, 5 und einer jeweiligen durch die Außenelektrode 4, 5 kontaktierten Innenelektrode 6, 7 des Piezostapels 2 bereitstellt.

Der erfindungsgemäße piezokeramische Vielschicht-Aktor 1 wird vorzugsweise in einem Einspritzsystem eines Kraftfahrzeuges eingesetzt. Dabei wird der Vielschicht-Aktor 1 insbesondere im Hochdruckraum des Einspritzsystems angeordnet. Das Einspritzsystems ist vorzugsweise als Common-Rail-Einspritzsystem ausgebildet.

Obwohl die vorliegende Erfindung vorstehenden anhand der bevorzugten Ausführungsbeispiele beschrieben wurde, ist sie darauf nicht beschränkt, sondern auf vielfältige. Art und Weise modifizierbar. Beispielsweise können der Vielschicht-Aktor und somit insbesondere auch der Piezo-Stapel und die Außenelektrode eine rechteckige Querschnittsform und oder auch jede beliebige Querschnittsform aufweisen.

## Patentansprüche

1. Piezokeramischer Vielschicht-Aktor (1) mit einem Piezostapel (2), der eine Vielzahl N von Piezoschichten (3) aufweist, mit zumindest einer dehnfähigen Außenelektrode (4, 5) die zumindest zwei Strompfade (I1, I2) zwischen einem Versorgungspotentialanschlussbereich (4a, 5a) der Außenelektrode (4, 5) und einer jeweiligen durch die Außenelektrode (4, 5) kontaktierten Innenelektrode (6, 7) des Piezostapels (2) bereitstellt, wobei der Piezostapel (2) eine Vielzahl N von ersten Innenelektroden (6) und eine Vielzahl N von zweiten Innenelektroden (7) aufweist, wobei eine Piezoschicht (3) zwischen einer ersten Innenelektrode (6) und einer zweiten Innenelektrode (7) angeordnet ist und die Vielzahl N erster Innenlektroden (6) mit einer ersten Außenelektrode (4) und die Vielzahl N zweiter Innenelektroden (7) mit einer zweiten Außenelektrode (5) elektrisch gekoppelt ist, wobei die erste Außenelektrode (4) und die zweite Außenelektrode (5) den Piezostapel (4) mit einer ersten Metallisierung (9), welche die N ersten Innenelektroden (6) elektrisch kontaktiert, und die zweite Außenelektrode (4) mit einer zweiten Metallisierung (10), welche die N zweiten Innenelektroden (7) elektrisch kontaktiert, verbunden sind, wobei die Außenelektrode (4) aufweist:
- den Versorgungspotenzialanschlussbereich (4a);
- eine Vielzahl von N Fingern (18a - 18f), welche parallel auf eine Metallisierung (9) jeweils im Bereich einer Innenelektrode (6a - 6e) elektronisch kontaktiert sind;
- eine in axialer Richtung des Piezo-Stapels (2) parallel angeordnete Vielzahl N von Kontaktstegen (24a - 24f), welche den Piezo-Stapel (2) in Umfangsrichtung umspannen und einen ersten Abstand (Δ1) zum Piezo-Stapel (2) aufweisen, wobei jeweils zwei benachbarte Kontaktstege (24a - 24f) mittels zumindest eines in Umfangsrichtung angeordnete Schlitzes (25a - 25r) zur Erhöhung der Dehnungsfähigkeit der Außenelektrode (4) voneinander getrennt sind und mittels zumindest eines in Längsrichtung des Piezo-Stapels (2) angeordneten Brückenabschnitts (26a - 26n) zur Stromführung miteinander verbunden sind;
- eine in Querrichtung des Piezo-Stapels (2) angeordnete Vielzahl N von Verbindungsabschnitten (27a - 27f), wobei jeweils ein Verbindungsabschnitt (27a - 27f) einen jeweiligen Finger (28a - 28e) mit dem entsprechenden Kontaktsteg (24a - 24f) elektrisch verbindet, wobei die in Längsrichtung benachbarten Schlitze in Umfangsrichtung versetzt zueinander angeordnet sind.

2. Piezoelektrischer Vielschicht-Aktor (1) mit einem Piezostapel (2), der eine Vielzahl N von Piezoschichten (3) aufweist, mit zumindest einer dehnfähigen Außenelektrode (4, 5) die zumindest zwei Strompfade 8I1, I2) zwischen einem Versorgungspotentialanschlussbereich (4a, 5a) der Außenelektrode (4, 5) und einer jeweiligen durch die Außenelektrode (4, 5) kontaktierten Innenelektrode (6, 7) des Piezostapels (2) bereitstellt, wobei der Piezostapel (2) eine Vielzahl N von ersten Innenelektroden (6) und eine Vielzahl N von zweiten Innenelektroden (7) angeordnet ist und die Vielzahl N erster Innenelektroden (6) mit einer ersten Außenelektrode (4) und die Vielzahl N zweiter Innenelektroden (7) mit einer zweiten Außenelektrode (4) und die zweiten Außenelektrode (5) den Piezostapel (2) im Wesentlichen umspannen, wobei die erste Außenelektrode (4) mit einer ersten Metallisierung (9), welche die N ersten Innenelektroden (6) elektrisch kontaktiert, und die zweite Außenelektrode (4) mit einer zweiten Metallisierung (10), welche die N zweiten Innenelektroden (7) elektrisch kontaktiert, verbunden sind, wobei die Außenelektrode (4) aufweist:
- den Versorgungspotentialanschlussbereich (4a);
- einen in Längsrichtung des Piezo-Stapels (2) angeordneten, ersten mäanderförmigen Abschnitt (28), welcher mit dem Versorgungspotenzialanschlussbereich (4a) elektrisch gekoppelt ist und welcher eine Vielzahl N/2 von ersten Kurvenabschnitten (29a - 29g) aufweist;
- einen parallel zum ersten mäanderförmigen Abschnitt (28) angeordneten, zweiten mäanderförmigen Abschnitt (30), welcher mit dem Versorgungspotenzialanschlussbereich (4a) elektrisch gekoppelt ist und welcher eine Vielzahl N/2 von zweiten Kurvenabschnitten (31a - 31g) aufweist; und
- eine Vielzahl von N Fingern (18a - 18m), welche parallel auf der Metallisierung (9) jeweils im Bereich einer Innenelektrode (6a - 6e) elektrisch kontaktiert sind und welche alternierend mit dem ersten mäanderförmigen Abschnitt (28) oder mit dem zweiten mäanderförmigen Abschnitt (30) elektrisch gekoppelt sind.

3. Piezokeramischer Vielschicht-Aktor nach Anspruch 1 oder 2,
**dadurch gekennzeichnet,**
**dass** der Piezostapel (2) kreiszylindrisch ausgebildet ist.

4. Piezokeramischer Vielschicht-Aktor nach Anspruch 1, 2 oder 3,
**dadurch gekennzeichnet,**
**dass** die Außenelektrode (4, 5) eine im Wesentlichen an eine Mantelfläche (8) des Piezostapels (2) angepasste flächige Form aufweist und den Piezostapel (2) zumindest teilweise umgibt.

5. Piezokeramischer Vielschicht-Aktor nach einem der Ansprüche 1 bis 4,
**dadurch gekennzeichnet,**
**dass** die Außenelektrode (4, 5) als ein im Wesentlichen an eine Mantelfläche (8) des Piezostapels (2) angepasstes flächiges Streckmetall oder Lochblech oder Drahtnetz oder Rohrfeder ausgebildet ist.

6. Piezokeramischer Vielschicht-Aktor nach Anspruch 4 oder 5,
**dadurch gekennzeichnet,**
**dass** die Außenelektrode (4, 5) einen Bereich von 30 % bis 50 %, bevorzugt 40 % bis 49 %, besonders bevorzugt 45 % bis 49 %, eines halben Umfangs des Piezo-Stapels (2) umspannt.

7. Piezokeramischer Vielschicht-Aktor nach Anspruch 2,
**dadurch gekennzeichnet,**
**dass** jeder (2n)-te Finger (18a, 18c, 19e, 18g, 18i, 18k, 18m), mit n ∈ [1,...,N], mit dem jeweiligen ersten Kurvenabschnitt (29a - 29g) und jeder (2n+1)-te Finger (18b, 18d, 18f, 18h, 18j, 181) mit dem jeweiligen zweiten Kurvenabschnitt (31a - 31g) verbunden ist.

8. Piezokeramischer Vielschicht-Aktor nach Anspruch 2 oder 7,
**dadurch gekennzeichnet,**
**dass** jeder Finger (18a - 18m) im Bereich eines Scheitelpunktes des entsprechenden Kurvenabschnitts (29a - 29g; 31a - 31g) mit dem entsprechenden Kurvenabschnitt (29a - 29g; 31a - 31g) verbunden ist.

9. Piezokeramischer Vielschicht-Aktor nach einem der Ansprüche 2, 7 oder 8,
**dadurch gekennzeichnet,**
**dass** die Außenelektrode (4) mit der ersten Metallisierung (9) mittels einer Schweißverbindung oder mittels zumindest eines Bondingdrahtes und/oder die zweite Außenelektrode (5) mit der zweiten Metallisierung (10) mittels einer Schweißverbindung oder mittels zumindest eines Bondingdrahtes verbunden sind/ist oder die erste Außenelektrode (4) und die erste Metallisierung (9) einstückig ausgebildet sind und/oder die zweite Außenelektrode (5) und die zweite Metallisierung (10) einstückig ausgebildet sind.

10. Piezokeramischer Vielschicht-Aktor nach einem der Ansprüche 1, 2, 7, 8 oder 9,
**dadurch gekennzeichnet,**
**dass** der Piezostapel (2) eine erste Freistellung (11) in der Mantelfläche (8) des Piezostapels (2) aufweist, in der die erste Metallisierung (9) angeordnet ist, und/oder eine zweite Freistellung (12) in der Mantelfläche (8) des Piezostapels (2) aufweist, in der die zweite Metallisierung (10) angeordnet ist.

11. Piezokeramischer Vielschicht-Aktor nach Anspruch 10,
**dadurch gekennzeichnet,**
**dass** die erste Freistellung (11) derart tief ist, dass die erste Metallisierung (9) innerhalb des durch den Radius (r) des zylinderförmigen Piezostapels (2) bestimmten Raumes verläuft und/oder die zweite Freistellung (12) derart tief ist, dass die zweite Metallisierung (10) innerhalb des durch den Radius (r) des zylinderförmigen Piezostapels (2) bestimmten Raumes verläuft.

12. Piezokeramischer Vielschicht-Aktor nach einem oder mehreren der vorstehenden Ansprüche,
**dadurch gekennzeichnet,**
**dass** eine zumindest den Piezostapel (2), die erste Außenelektrode (4) und die zweite Außenelektrode (5) umgebende Umhüllung (13) vorgesehen ist.

13. Piezokeramischer Vielschicht-Aktor nach Anspruch 12,
**dadurch gekennzeichnet,**
**dass** die erste Außenelektrode (4) und die zweite Außenelektrode (5) dazu geeignet sind, einen außen an der Umhüllung anliegenden Druck (P) auf den Piezostapel (2) zu übertragen.

14. Piezokeramischer Vielschicht-Aktor nach Anspruch 12 oder 13,
**dadurch gekennzeichnet,**
**dass** die Umhüllung (13) als ein Wellrohr ausgebildet ist, das eine Vielzahl von M Wellen aufweist und insbesondere metallisch ist.

15. Piezokeramischer Vielschicht-Aktor nach einem oder mehreren der Ansprüche 12 bis 14,
**dadurch gekennzeichnet,**
**dass** eine erste Passivierungsschicht (14) zwischen dem Piezostapel (2) und den Außenelektroden (4, 5) und eine zweite Passivierungsschicht (15) zwischen den Außenelektroden (4, 5) und der Umhüllung (13) vorgesehen ist.

16. Piezokeramischer Vielschicht-Aktor nach Anspruch 15,
**dadurch gekennzeichnet,**
**dass** die erste Passivierungsschicht (14) und/oder die zweite Passivierungsschicht (15) im Wesentlichen aus einem Elastomer, insbesondere Teflon, oder aus einem Gel bestehen.

17. Piezokeramischer Vielschicht-Aktor nach Anspruch 16,
**dadurch gekennzeichnet,**
**dass** die erste Passivierungsschicht (14) und/oder die zweite Passivierungsschicht (15) eine Härte von zumindest 70 Shore A aufweisen.

18. Piezokeramischer Vielschicht-Aktor nach einem oder mehreren der vorstehenden Ansprüche 14 bis 17,
**dadurch gekennzeichnet,**
**dass** ein O-Ringförmiges Stützelement in zumindest einer Welle des Wellrohres (13) vorgesehen ist, welches insbesondere aus einem Elastomer, beispielsweise Teflon, besteht.

19. Piezokeramischer Vielschicht-Aktor nach einem oder mehreren der vorstehenden Ansprüche 14 bis 18,
**dadurch gekennzeichnet,**
**dass** das Wellrohr (13) als ein längs- und/oder querdehnfähiges Wellrohr ausgebildet ist.

20. Piezokeramischer Vielschicht-Aktor nach einem oder mehreren der vorstehenden Ansprüche,
**dadurch gekennzeichnet,**
**dass** der Vielschicht-Aktor (1) kreiszylindrisch ausgebildet ist.

21. Piezokeramischer Piezo-Aktor nach einem oder mehreren der vorstehenden Ansprüche,
**dadurch gekennzeichnet,**
**dass** ein Anschluß (16, 17) vorgesehen ist, welcher den Versorgungspotentialanschlussbereich (4a, 5a) der Außenelektrode (4, 5) zur Versorgung der entsprechenden Innenelektrode (6, 7) mit einem Versorgungspotential kontaktiert.

22. Verfahren zum Herstellen eines piezokeramischen Vielschicht-Aktors nach einem oder mehreren der vorstehenden Ansprüche 1 bis 21, mit den Schritten:
(a) Bereitstellen eines Piezostapels (2) der eine Vielzahl N von Piezoschichten (3) aufweist; und
(b) Anordnen zumindest einer dehnfähigen Außenelektrode (4, 5) an dem Piezostapel (2) derart, dass zumindest zwei Strompfade (I1, I2) zwischen einem Versorgungspotentialanschlussbereich (4a, 5a) der Außenelektrode (4, 5) und einer jeweiligen durch die Außenelektrode (4, 5) kontaktierten Innenelektrode (6, 7) des Piezostapels (2) bereitgestellt werden.

23. Einspritzsystem mit einem piezokeramischen Vielschicht-Aktor (1) nach einem oder mehreren der Ansprüche 1 bis 21, wobei der Vielschicht-Aktor (1) in einem Hochdruckraum des Einspritzsystems angeordnet ist.

24. Einspritzsystem nach Anspruch 23,
**dadurch gekennzeichnet,**
**dass** das Einspritzsystem als ein Common-Rail-Einspritzsystem ausgebildet ist.

## Claims

1. Piezoceramic multilayer actuator (1) with a piezo-stack (2), which has a plurality N of piezo layers (3) having at least one expandable outer electrode (4, 5) which provides at least two current paths (I1, I2) between a supply potential connecting area (4a, 5a) of the outer electrode (4, 5) and a respective inner electrode (6, 7) of the piezo-stack (2) with which the outer electrode (4, 5) makes contact, wherein the piezo-stack (2) has a plurality N of first inner electrodes (6) and a plurality N of second inner electrodes (7), with a piezo layer (3) being arranged between a first inner electrode (6) and a second inner electrode (7) and the plurality N of first inner electrodes (6) being electrically coupled to a first outer electrode (4) and the plurality N of second inner electrodes (7) to a second outer electrode (5), wherein the first outer electrode (4) and the second outer electrode (5) essentially span the piezo-stack (2), with the first outer electrode (4) being connected to a first metallization (9), which electrically contacts the N first inner electrodes (6) and the second outer electrode (4) to a second metallization (10), which electrically contacts the N second inner electrodes (7)
wherein the outer electrode (4) comprises:
- the supply potential connecting area (4a);
- a plurality of N fingers (18a - 18f), which are electronically contacted parallel to a metallization (9) in the area of an inner electrode (6a - 6e) in each case;
- a plurality N of contact links (24a - 24f) arranged in parallel in the axial direction of the piezo-stack (2), which span the piezo-stack (2) in the circumferential direction and feature a first distance (Δ1) to the piezo-stack (2), with two adjacent contact links in each case (24a - 24f) being separated from each other by means of at least one slot (25a - 25r) arranged in the circumferential direction in order to increase the expansion capacity of the outer electrode (4) and being connected to each other by means of at least one bridge section (26a - 26n) arranged in the longitudinal direction of the piezo-stack (2) for conveying the current;
- a plurality N of connecting sections (27a - 27f) arranged in the transverse direction of the piezo-stack (2), with one connecting section (27a - 27f) in each case electrically connecting one specific finger (28a - 28e) to the corresponding contact link (24a - 24f), wherein the adjacent slots in the circumferential direction are arranged offset to one another.

2. Piezoceramic multilayer actuator (1) with a piezo-stack (2), which has a plurality N of piezo layers (3) having at least one expandable outer electrode (4, 5) which provides at least two current paths (I1, I2) between a supply potential connecting area (4a, 5a) of the outer electrode (4, 5) and a respective inner electrode (6, 7) of the piezo-stack (2) with which the outer electrode (4, 5) makes contact, wherein the piezo-stack (2) has a plurality N of first inner electrodes (6) and a plurality N of second inner electrodes (7), with a piezo layer (3) being arranged between a first inner electrode (6) and a second inner electrode (7) and the plurality N of first inner electrodes (6) being electrically coupled to a first outer electrode (4) and the plurality N of second inner electrodes (7) to a second outer electrode (5), wherein the first outer electrode (4) and the second outer electrode (5) essentially span the piezo-stack (2), with the first outer electrode (4) being connected to a first metallization (9), which electrically contacts the N first inner electrodes (6) and the second outer electrode (4) to a second metallization (10), which electrically contacts the N second inner electrodes (7)
the outer electrode (4) comprises:
- the supply potential connecting area (4a);
- a first serpentine section (28) arranged in a longitudinal direction of the piezo-stack (2), which is electrically coupled to the supply potential connecting area (4a) and which features a plurality N/2 of first curve sections (29a - 29g);
- a second serpentine section (30) arranged in parallel to the first serpentine section (28), which is electrically coupled to the supply potential connecting area (4a) and which features a plurality N/2 of second curve sections (31a - 31g); and
- a plurality of N fingers (18a - 18m), which are electrically contacted in parallel to the metallization (9) in each case in the area of an inner electrode (6a - 6e) and which are electrically coupled in an alternating manner to the first serpentine section (28) or to the second serpentine section (30).

3. Piezoceramic multilayer actuator in accordance with claim 1 or 2,
**characterised in that,**
the piezo-stack (2) has a circular cylindrical shape.

4. Piezoceramic multilayer actuator in accordance with claim 1, 2 or 3,
**characterised in that**
the outer electrode (4, 5) essentially has a flat shape adapted to a peripheral surface (8) of the piezo-stack (2) and at least partly surrounds the piezo-stack (2).

5. Piezoceramic multilayer actuator in accordance with one of claims 1 to 4,
**characterised in that**
the outer electrode (4, 5) is essentially embodied as a flat expanded metal or a perforated sheet or a wire mesh, or tubular spring, adapted to the peripheral surface (8) of the piezo-stack (2).

6. Piezoceramic multilayer actuator in accordance with claim 4 or 5,
**characterised in that,**
the outer electrode (4, 5) spans an area ranging from 30% to 50%, preferably from 40% to 49%, particularly preferably from 45% to 49% of half the circumference of the piezo-stack (2).

7. Piezoceramic multilayer actuator in accordance with claim 2,
**characterised in that**
each (2n)th finger (18a, 18c, 18e, 18g, 18i, 18k, 18m), with n∈ [1,...,N], is connected to the specific first curve section (29a - 29g) and each (2n+1) th finger (18b, 18d, 18f, 18h, 18j, 181) to the specific second curve section (31a - 31g).

8. Piezoceramic multilayer actuator in accordance with claim 2 or 7,
**characterised in that,**
each finger (18a - 18m) in the area of a vertex of the corresponding curve section (29a - 29g; 31a - 31g) is connected to the corresponding curve section (29a - 29g; 31a - 31g).

9. Piezoceramic multilayer actuator in accordance with one of claims 2, 7 or 8,
**characterised in that**
the outer electrode (4) with the first metallization (9) is connected by means of a welded joint or by means of at least one bonding wire (not shown) and/or the second outer electrode (5) with the second metallization (10) is connected by means of a welded joint or by means of at least one bonding wire in a preferred manner or the first outer electrode (4) and the first metallization (9) and/or the second outer electrode (5) and the second metallization (10) are embodied in one piece.

10. Piezoceramic multilayer actuator in accordance with one of claims 1, 2, 7, 8 or 9,
**characterised in that**
the piezo-stack (2) has a first recess (11) in the peripheral surface (8) of the piezo-stack (2) in which the first metallization (9) is arranged and/or has a second recess (12) in the peripheral surface (8) of the piezo-stack (2) in which the second metallization (10) is arranged.

11. Piezoceramic multilayer actuator in accordance with claim 10,
**characterised in that**
the first recess (11) is so deep that the first metallization (9) runs in such a way within the space determined by the radius (r) of the cylindrical piezo-stack (2) and/or the second recess (12) that the second metallization (10) runs within the space determined by the radius (r) of the cylindrical piezo-stack (2).

12. Piezoceramic multilayer actuator in accordance with one or more of the preceding claims,
**characterised in that**
provision has been made for a sleeve (13) which encloses at least the piezo-stack (2), the first outer electrode (4), and the second outer electrode (5).

13. Piezoceramic multilayer actuator in accordance with claim 12,
**characterised in that**
the first outer electrode (4) and the second outer electrode (5) are suited for transmitting a pressure (P) applied on the outside to the sleeve of the piezo-stack (2).

14. Piezoceramic multilayer actuator in accordance with claim 12 or 13,
**characterised in that**
the sleeve (13) is embodied as a corrugated tube which has a plurality of M corrugations and is in particular metallic.

15. Piezoceramic multilayer actuator in accordance with one or more of claims 12 to 14,
**characterised in that**
provision has been made for a first passivation layer (14) between the piezo-stack (2) and the outer electrodes (4, 5) and a second passivation layer (15) between the outer electrodes (4, 5) and the sleeve (13).

16. Piezoceramic multilayer actuator in accordance with claim 15,
**characterised in that**
the first passivation layer (14) and/or the second passivation layer (15) essentially consist of an elastomer, in particular Teflon, or a gel.

17. Piezoceramic multilayer actuator in accordance with claim 16,
**characterised in that**
the first passivation layer (14) and/or the second passivation layer (15) have a Shore A hardness of at least 70.

18. Piezoceramic multilayer actuator in accordance with one or more or the preceding claims 14 to 17,
**characterised in that,**
provision has been made for at least one 0-ring shaped supporting element in at least one corrugation of the corrugated tube (13), which in particular consists of an elastomer, for example Teflon.

19. Piezoceramic multilayer actuator in accordance with one or more or the preceding claims 14 to 18,
**characterised in that,**
the corrugated tube (13) is embodied as a longitudinal corrugated tube and/or a corrugated tube which can expand in a transverse direction.

20. Piezoceramic multilayer actuator in accordance with one or more or the preceding claims,
**characterised in that**
the multilayer actuator (1) has a circular cylindrical shape.

21. Piezoceramic multilayer actuator in accordance with one or more of the preceding claims,
**characterised in that,**
provision has been made for a connection (16, 17), which contacts the supply potential connecting area (4a, 5a) of the outer electrode (4, 5) for supplying the corresponding inner electrode (6, 7) with a supply potential.

22. Method for producing a piezoceramic multilayer actuator in accordance with one or more of above claims 1 to 21, with the steps:
(a) providing a piezo-stack (2) which has a plurality N of piezo layers (3); and
(b) arranging at least one outer electrode (4, 5) which can expand on the piezo-stack (2) in such a way that at least two current paths (I1, I2) are provided between a supply potential connecting area (4a, 5a) of the outer electrode (4, 5) and a respective inner electrode (6, 7), with which the outer electrode (4, 5) makes contact, of the piezo-stack (2).

23. Injection system with a piezoceramic multilayer actuator (1) in accordance with one or more of claims 1 to 21, with the multilayer actuator (1) being arranged in a high-pressure chamber of the injection system.

24. Injection system in accordance with claim 23,
**characterised in that,**
the injection system is embodied as a common rail injection system.

## Revendications

1. Actionneur piézocéramique multicouche (1) comprenant un empilement piézoélectrique (2), qui présente une pluralité N de couches piézoélectriques (3), au moins une électrode externe extensible (4, 5) qui permet au moins deux trajets de courant (I1, I2) entre une zone de connexion de potentiel d'alimentation (4a, 5a) de l'électrode externe (4, 5) et une électrode interne (6, 7) respective de l'empilement piézoélectrique (2) connectée par l'électrode externe (4, 5), dans lequel l'empilement piézoélectrique (2) présente une pluralité N de premières électrodes internes (6) et une pluralité N de secondes électrodes internes (7), dans lequel une couche piézoélectrique (3) est agencée entre une première électrode interne (6) et une seconde électrode interne (7) et la pluralité N de premières électrodes internes (6) est couplée électriquement à une première électrode externe (4) et la pluralité N de secondes électrodes internes (7) est couplée électriquement à une seconde électrode externe (5), dans lequel la première électrode externe (4) et la seconde électrode externe (5) relient l'empilement piézoélectrique (2) à une première métallisation (9), laquelle connecte électriquement les N premières électrodes internes (6), et la deuxième électrode externe (4) à une seconde métallisation (10), laquelle connecte électriquement les N secondes électrodes internes (7), dans lequel l'électrode externe (4) présente :
- la zone de connexion de potentiel d'alimentation (4a) ;
- une pluralité de N doigts (18a à 18f), qui sont connectés électroniquement parallèlement sur une métallisation (9) respectivement dans la zone d'une électrode interne (6a à 6e) ;
- une pluralité N de barrettes de contact (24a à 24f) agencées parallèlement dans la direction axiale de l'empilement piézoélectrique (2), lesquelles enserrent l'empilement piézoélectrique (2) dans la direction périphérique et présentent un premier intervalle (Δ1) avec l'empilement piézoélectrique (2), dans lequel respectivement deux barrettes de contact voisines (24a à 24f) sont séparées l'une de l'autre au moyen d'au moins une fente (25a à 25r) ménagée dans la direction périphérique pour augmenter la capacité d'extension de l'électrode externe (4) et sont reliées l'une à l'autre au moyen d'au moins une section de pont (26a à 26n) agencée dans la direction longitudinale de l'empilement piézoélectrique (2) pour acheminer le courant;
- une pluralité N de sections de connexion (27a à 27f) agencées dans la direction transversale de l'empilement piézoélectrique (2), dans lequel respectivement une section de connexion (27a à 27f) relie électriquement un doigt respectif (28a à 28e) à la barrette de contact (24a à 24f) correspondante, dans lequel les fentes voisines dans la direction longitudinale sont agencées décalées les unes des autres dans la direction périphérique.

2. Actionneur piézoélectrique multicouche (1) comprenant un empilement piézoélectrique (2), qui présente une pluralité N de couches piézoélectriques (3), au moins une électrode externe extensible (4, 5), qui permet au moins deux trajets de courant (I1, I2) entre une zone de connexion de potentiel d'alimentation (4a, 5a) de l'électrode externe (4, 5) et une électrode interne (6, 7) respective de l'empilement piézoélectrique (2) connectée par l'électrode externe (4, 5), dans lequel on a agencé sur l'empilement piézoélectrique (2) une pluralité N de premières électrodes internes (6) et une pluralité N de secondes électrodes internes (7) et la pluralité N de premières électrodes internes (6) avec une première électrode externe (4) et la pluralité N de secondes électrodes internes (7) avec une seconde électrode externe (4) et la seconde électrode externe (5) enserrent sensiblement l'empilement piézoélectrique (2), dans lequel la première électrode externe (4) e s t reliée à u n e p r e m i è r e métallisation (9), laquelle connecte électriquement les N premières électrodes internes (6), et la seconde électrode externe (4) est reliée à une seconde métallisation (10) laquelle connecte électriquement les N secondes électrodes internes (7), dans lequel l'électrode externe (4) présente :
- la zone de connexion de potentiel d'alimentation (4a) ;
- une première section (28) en forme de méandre agencée dans la direction longitudinale de l'empilement piézoélectrique (2) laquelle section est couplée électriquement à la zone de connexion de potentiel d'alimentation (4a) et présente une pluralité N/2 de premières sections courbes (29a à 29g) ;
- une seconde section (30) en forme de méandre agencée parallèlement à la première section (28) en forme de méandre et qui est couplée électriquement à la zone de connexion de potentiel d'alimentation (4a) et présente une pluralité N/2 de secondes sections courbes (31a à 31g) ; et
- une pluralité de N doigts (18a à 18m), qui se connectent électriquement parallèlement sur la métallisation (9) respectivement dans la zone d'une électrode interne (6a à 6e) et sont couplées électriquement en alternance à la première section (28) en forme de méandre ou à la seconde section (30) en forme de méandre.

3. Actionneur piézocéramique multicouche selon la revendication 1 ou 2,
**caractérisé en ce que**
l'empilement piézoélectrique (2) est formé de manière cylindrique circulaire.

4. Actionneur piézocéramique multicouche selon la revendication 1, 2 ou 3,
**caractérisé en ce que**,
l'électrode externe (4, 5) présente une forme plate sensiblement adaptée à une surface enveloppante (8) de l'empilement piézoélectrique et entoure au moins en partie l'empilement piézoélectrique (2).

5. Actionneur piézocéramique multicouche selon l'une quelconque des revendications 1 à 4,
**caractérisé en ce que**
l'électrode externe (4, 5) se présente sous la forme d'un métal étiré ou d'une tôle perforée ou d'un treillis en fil métallique ou d'un tube-ressort plat sensiblement adapté à une surface enveloppante (8) de l'empilement piézoélectrique (2).

6. Actionneur piézocéramique multicouche selon la revendication 4 ou 5,
**caractérisé en ce que**,
l'électrode externe (4, 5) enserre une zone de 30 à 50 %, de préférence de 40 à 49 %, mieux encore de 45 à 4 9 %, d'une demi-étendue de l'empilement piézoélectrique (2).

7. Actionneur piézocéramique multicouche selon la revendication 2,
**caractérisé en ce que**,
chaque (2n)^{è} doigt (18a, 18c, 19e, 18g, 18i, 18k, 18m), avec n ∈ [1, ..., N], est relié à la première section courbe (29a à 29g) respective, et chaque (2n+1)^{è} doigt (18b, 18d, 18f, 18h, 18j, 181) est relié à la seconde section courbe (31a à 31g) respective.

8. Actionneur piézocéramique multicouche selon la revendication 2 ou 7,
**caractérisé en ce que**,
chaque doigt (18a à 18m) est relié à la section courbe correspondante (29a à 29g ; 31a à 31g) dans la zone du sommet de la section courbe correspondante (29a à 29g ; 31a à 31g).

9. Actionneur piézocéramique multicouche selon l'une quelconque des revendications 2, 7 ou 8
**caractérisé en ce que**,
l'électrode externe (4) est reliée à la première métallisation (9) au moyen d'une liaison soudée ou au moyen d'au moins un fil de liaison et/ou la seconde électrode externe (5) est reliée à la seconde métallisation (10) au moyen d'une liaison soudée ou au moyen d'au moins un fil de liaison, ou bien la première électrode externe (4) et la première métallisation (9) sont formées d'un seule tenant et/ou la seconde électrode externe (5) et la seconde métallisation (10) sont formées d'un seul tenant.

10. Actionneur piézocéramique multicouche selon l'une quelconque des revendications 1, 2, 7, 8 ou 9
**caractérisé en ce que**
l'empilement piézoélectrique (2) présente une première position libre (11) dans la surface enveloppante (8) de l'empilement piézoélectrique (2) dans laquelle position la première métallisation (9) est agencée, et/ou une seconde position libre (12) dans la surface enveloppante (8) de l'empilement piézoélectrique (2) dans laquelle position la seconde métallisation (10) est agencée.

11. Actionneur piézocéramique multicouche selon la revendication 10,
**caractérisé en ce que**
la première position libre (11) est suffisamment profonde pour que la première métallisation (9) s'étende à l'intérieur de l'espace déterminé par le rayon (r) de l'empilement piézoélectrique (2) de forme cylindrique et/ou la seconde position libre (12) est suffisamment profonde pour que la seconde métallisation (10) s'étende à l'intérieur de l'espace déterminé par le rayon (r) de l'empilement piézoélectrique (2) en forme de cylindre.

12. Actionneur piézocéramique multicouche selon une ou plusieurs des revendications précédentes,
**caractérisé en ce que**
il est prévu une gaine (13) entourant au moins l'empilement piézoélectrique (2), la première électrode externe (4) et la seconde électrode externe (5).

13. Actionneur piézocéramique multicouche selon la revendication 12,
**caractérisé en ce que**
la première électrode externe (4) et la seconde électrode externe (5) conviennent pour transférer à l'empilement piézoélectrique (2) une pression (P) appliquée extérieurement sur la gaine.

14. Actionneur piézocéramique multicouche selon la revendication 12 ou 13,
**caractérisé en ce que**
la gaine (13) se présente sous la forme d'un tube ondulé qui présente une pluralité de M ondulations et est en particulier métallique.

15. Actionneur piézocéramique multicouche selon une ou plusieurs des revendications 12 à 14,
**caractérisé en ce que**
il est prévu une première couche de passivation (14) entre l'empilement piézoélectrique (2) et les électrodes externes (4, 5) et une seconde couche de passivation (15) entre les électrodes externes (4, 5) et la gaine (13).

16. Actionneur piézocéramique multicouche selon la revendication 15,
**caractérisé en ce que**
la première couche de passivation (14) et/ou la seconde couche de passivation (15) est ou sont constituées sensiblement d'un élastomère, en particulier le Téflon, ou d'un gel.

17. Actionneur piézocéramique multicouche selon la revendication 16,
**caractérisé en ce que**
la première couche de passivation (14) et/ou la seconde couche de passivation (15) présente(nt) une dureté d'au moins 70 Shore A.

18. Actionneur piézocéramique multicouche selon une ou plusieurs des revendications 14 à 17,
**caractérisé en ce que**
il est prévu un élément d'appui en forme de joint torique dans au moins une ondulation du tube ondulé (13), qui est constitué en particulier d'un élastomère, par exemple du Téflon.

19. Actionneur piézocéramique multicouche selon une ou plusieurs des revendications 14 à 18,
**caractérisé en ce que**
le tube ondulé (13) se présente sous la forme d'un tube ondulé extensible longitudinalement et/ou transversalement.

20. Actionneur piézocéramique multicouche selon une ou plusieurs des revendications précédentes,
**caractérisé en ce que**
l'actionneur multicouche (1) se présente sous une forme cylindrique circulaire.

21. Actionneur piézocéramique multicouche selon une ou plusieurs des revendications précédentes,
**caractérisé en ce que**
il est prévu une connexion (16, 17) qui connecte la zone de connexion de potentiel d'alimentation (4a, 5a) de l'électrode externe (4, 5) à un potentiel d'alimentation pour alimenter l'électrode interne correspondante (6, 7).

22. Procédé de fabrication d'un actionneur piézocéramique multicouche selon une ou plusieurs des précédentes revendications 1 à 21, avec les étapes consistant à :
(a) préparer un empilement piézoélectrique (2) qui présente une pluralité N de couches piézoélectriques (3) ; et
(b) agencer au moins une électrode externe extensible (4, 5) sur l'empilement piézoélectrique de manière à permettre au moins deux trajets de courant (I1, I2) soient formés entre une zone de connexion de potentiel d'alimentation (4a, 5a) de l'électrode externe (4, 5) et une électrode interne (6, 7) respective de l'empilement piézoélectrique (2) connectée par l'électrode externe (4, 5).

23. Système d'injection avec un actionneur piézocéramique multicouche (1) selon une ou plusieurs des revendications 1 à 21, dans lequel l'actionneur multicouche (1) est agencé dans un espace sous haute pression du système d'injection.

24. Système d'injection selon la revendication 23,
**caractérisé en ce que**
le système d'injection se présente sous la forme d'un système d'injection à rampe commune.
